# EUROPÄISCHE PATENTANMELDUNG

(11) **EP 1 154 326 A1**
(43) Veröffentlichungstag der Anmeldung: **14.11.2001**
(21) Anmeldenummer: 00110060.1
(22) Anmeldetag: 12.05.2000
(51) Int. Cl.: G03F 7/20, G03F 1/00, B41C 1/18

(54) **Verfahren und Vorrichtung zur Herstellung von Druckplatten**

(71) Anmelder: Schablonentechnik Kufstein Aktiengesellschaft, 6330 Kufstein (AT)
(72) Erfinder: Juffinger, Josef, 6335 Thiersee (AT)
(74) Vertreter: TER MEER STEINMEISTER & PARTNER GbR

(57) **Zusammenfassung**

Bei der Herstellung von Druckplatten wird wenigstens eine lichtempfindliche Druckplatte (2) auf die äußere Umfangsfläche eines Trägerzylinders (1) gelegt und auf diesem durch eine Bemusterungsmaske (4) hindurch belichtet. Dabei werden die Belichtungsstrukturen in der Druckplatte (2) im selben Krümmungszustand der Druckplatte erzeugt, unter dem diese auch beim Drucken verwendet wird, wenn sie auf eine zylindrische Walze entsprechenden Durchmessers aufgespannt wird. Musterverzerrungen in Umfangsrichtung der Druckwalze werden somit vermieden.

## Beschreibung

Die Erfindung betrifft ein Verfahren zur Herstellung von Druckplatten gemäß dem Anspruch 1 sowie eine Vorrichtung zur Herstellung derselben gemäß dem Anspruch 20.

Druckplatten nach der Erfindung bestehen aus flexiblem bzw. elastischem Material, z.B. Fotopolymermaterial, und können daher auch als Druckmatten bezeichnet werden. Sie sind im wesentlichen für den Hockdruck geeignet, um zum Beispiel Kartonagen, Papierblätter oder andere Gegenstände bedrucken zu können. Zu diesem Zweck werden die Druckplatten um die aüßere Umfangsfläche einer Druckwalze herumgelegt und dann rollend sowie unter Zufuhr von Druckfarbe über das zu bedruckende Gut geführt.

Herkömmlicherweise werden Druckplatten der genannten Art mit Hilfe eines Flachbelichters hergestellt. Dazu wird eine lichtempfindliche Druckplatte auf die ebene Oberfläche des Flachbelichters gelegt und mittels eines Films abgedeckt, in welchem sich das in die Druckplatte zu übertragende Muster befindet. Über den Film und die Druckplatte wird eine Folie gelegt, um anschließend den Raum unter der Folie zu evakuieren. Auf diese Weise kommen Film und Druckplatte dicht zur Anlage. Danach wird die lichtempfindliche Druckplatte durch die Folie und den Film hindurch belichtet, um das im Film vorhandene Muster in die Druckplatte zu übertragen. Diese Belichtung erfolgt mit einer ebenen Belichtungsanordnung oberhalb des Films, die z.B. eine Anzahl von nebeneinander liegenden Leuchtstoffröhren enthält, die UV-Strahlung aussenden. Die Druckplatte besteht aus einem Fotopolymer, das zum Beispiel bei Auftreffen von UV-Strahlung aushärtet. Nach durchgeführter Belichtung wird die Druckplatte entwickelt. Die nicht belichteten Bereiche der Druckplatte werden herausgewaschen.

Soll die entwickelte Druckplatte nun zum Drucken verwendet werden, wird sie auf der bereits genannten Druckwalze befestigt und um deren aüßere Oberfläche gelegt. Hierbei wird die Druckplatte gekrümmt, und zwar entsprechend der Krümmung der Druckwalze. Dies führt zu einer Verzerrung des in der Druckplatte vorhandenen Musters in Umfangsrichtung der Druckwalze und somit zu einer Verzerrung des durch die Druckplatte erzeugten Musters auf dem zu bedruckenden Gut.

Nach einem anderen bekannten Verfahren wird eine einseitig mit einer Rußschicht versehene Druckplatte aus einem Fotopolymer auf die Innenseite eines zylindrisch gekrümmten Trägers gelegt, derart, daß die Rußschicht vom Träger abgewandt ist. Mittels eines an der Seite der Rußschicht drehbar gelagerten Polygonspiegels wird ein Laserstrahl über die Rußschicht geführt, um diese Musterbedingt abzutragen. Anschließend wird die mit der strukturierten Rußschicht versehene Druckplatte in einem Flachbelichter mit der strukturierten Rußschicht als Belichtungsmaske belichtet. Danach erfolgt die Entwicklung der Druckplatte. Soll letztere zum Drucken verwendet werden, wird sie um die Oberfläche einer Druckwalze herumgelegt, so daß jetzt wiederum der bereits eingangs genannte Verzerrungseffekt auftritt, allerdings noch verstärkt, da das Muster bei der Belichtung zunächst an der konkaven Seite der Druckplatte lag, beim Drucken aber an der Konvexenseiten der Druckplatte zu liegen kommt.

Der Erfindung liegt die Aufgabe zugrunde, ein Verfahren und eine Vorrichtung anzugeben, um Druckplatten bzw. Druckmatten so herstellen zu können, daß sie beim Drucken verzerrungsärmere Muster erzeugen.

Die verfahrensseitige Lösung der gestellten Aufgabe ist im Anspruch 1 angegeben. Dagegen findet sich die vorrichtungsseitige Lösung der gestellten Aufgabe im Anspruch 20. Vorteilhafte Ausgestaltungen der Erfindung sind den jeweils nachgeordneten Unteransprüchen zu entnehmen.

Gemäß dem erfindungsgemäßen Verfahren zur Herstellung von Druckplatten wird wenigstens eine lichtempfindliche Druckplatte auf die äußere Umfangsfläche eines Trägerzylinders gelegt und auf diesem durch eine Bemusterungsmaske hindurch belichtet.

Wird nach Entwicklung der belichteten Druckplatte diese zum Zwecke des Druckens auf eine Druckwalze gelegt, die wenigstens annähernd den selben Durchmesser wie der zuvor erwähnte Trägerzylinder aufweist, so treten praktisch keine Verzerrungen des Druckmusters in Umfangsrichtung der Druckwalze mehr auf, was zu qualitativ hochwertigeren Drucken führt.

Nach der Erfindung gibt es mehrere Möglichkeiten, die Bemusterungsmaske zu bilden.

So läßt sich zum Beispiel die Bemusterungsmaske durch Strukturierung einer auf der lichtempfindlichen Druckplatte liegenden Abdeckschicht herstellen. Bei der Abdeckschicht handelt es sich um eine solche Schicht, die Strahlung blockiert, für die die lichtempfindliche Druckplatte empfindlich ist. Dabei kann die Abdeckschicht schon auf die Druckplatte aufgebracht worden sein, bevor letztere auf den Trägerzylinder gespannt wird. Möglich ist es aber auch, die Abdeckschicht auf die Druckplatte aufzubringen, nachdem diese auf den Trägerzylinder gelegt worden ist.

Bei der Abdeckschicht kann es sich zum Beispiel um einer Rußschicht oder auch um eine lichtempfindliche Schicht handeln, die z.B. im infraroten Strahlungsbereich empfindlich ist. Sie läßt sich in geeigneter Weise durch Bestrahlung strukturieren, etwa durch Verwendung fokussierter Strahlung bzw. Laserstrahlung. Im Falle einer als Rußschicht ausgebildeten Abdeckschicht könnte diese musterbedingt durch Laserstrahlung hoher Leistung abgetragen bzw. weggebrannt werden. Eine lichtempfindliche Abdeckschicht aus z.B. fotoempfindlichen Material könnte dagegen durch Belichtung und Entwicklung strukturiert werden.

Nach einer vorteilhaften Ausgestaltung der Erfindung erfolgt das Strukturieren der Abdeckschicht und das Belichten der lichtempfindlichen Druckplatte bei sich drehendem Trägerzylinder. Handelt es sich bei der Abdeckschicht um eine solche, die zur Bildung der Bemusterungsmaske belichtet und entwickelt werden muß, so könnte auch der Entwicklungsvorgang bei sich drehendem Trägerzylinder durchgeführt werden, so daß es nicht erforderlich ist, die Druckplatte zwischenzeitlich vom Trägerzylinder abzunehmen. Das Verfahren zur Herstellung der Druckplatte vereinfacht sich daher erheblich.

Handelt es sich dagegen bei der Abdeckschicht um eine solche, die durch Strahlung abgetragen werden kann, so kann bei sich drehendem Trägerzylinder das Abtragen der Abdeckschicht und das Belichten der lichtempfindlichen Druckplatte im selben Arbeitsgang durch in Längsrichtung des Trägerzylinders voneinander beabstandete Strahlungsquellen vorgenommen werden, wenn die Strahlungsquellen in Längsrichtung des Trägerzylinders bewegt werden. Dies führt zu einer ganz erheblichen Zeitersparnis bei der Herstellung der Druckplatten.

Andererseits läßt sich die Bemusterungsmaske auf der lichtempfindlichen Druckplatte auch dadurch herstellen, daß musterbedingt eine Abdeckflüssigkeit auf die Oberfläche der lichtempfindlichen Druckplatte aufgebracht wird. Dies kann auf verschiedene Weise erfolgen, etwa durch Aufspritzen von Flüssigkeit, durch Aufdrucken von Flüssigkeit oder Pasten, durch haftendes Aufbringen anderer lichtdichter Substanzen, und dergleichen.

Wird die Bemusterungsmaske durch Aufspritzen von Abdeckflüssigkeit gebildet, so kann zu diesem Zweck etwa flüssiges Wachs, Tinte, ein geeigneter Farbstoff oder gar flüssiges Metall zum Einsatz kommen. Hier könnte z.B. an sogenanntes Woodsches Metall gedacht werden.

Nach einer vorteilhaften Ausgestaltung der Erfindung kann das Aufbringen der Abdeckflüssigkeit oder auch eines anderen geeigneten pastösen oder festen sowie haftenden Abdeckmaterials und das Belichten der lichtempfindlichen Druckplatte bei sich drehendem Trägerzylinder erfolgen, was zu einer Vereinfachung des Herstellungsverfahrens führt. Dabei kann das Aufbringen des Abdeckmaterials bzw. der Abdeckflüssigkeit und das Belichten der lichtempfindlichen Druckplatte auch im selben Arbeitsgang durchgeführt werden, derart, daß entsprechend ausgebildete und in Längsrichtung des Trägerzylinders voneinander beabstandete Bearbeitungsstation bei sich drehendem Trägerzylinder in dessen Längsrichtung bewegt werden. Dabei schreitet die das Abdeckmaterial aufbringende Bearbeitungsstation voran, während die zur Belichtung der Druckplatte verwendete Bearbeitungsstation folgt.

Zudem ist es auch möglich, die Bemusterungsmaske dadurch herzustellen, daß eine Flüssigkeit (Inhibierungsflüssigkeit) aufgebracht wird, die bewirkt, daß das Fotopolymer an den benetzten Stellen strahlungsunempfindlich wird, also nicht mehr auf UV-Strahlung oder andere Strahlung anspricht.

Grundsätzlich ist es allerdings auch möglich, sämtliche Bemusterungsmasken der zuvor genannten Art auch bei ruhendem Trägerzylinder zu bilden. In diesem Fall müßten die entsprechenden Bearbeitungsstationen in zwei Richtungen bewegt werden.

Es könnte aber auch der Trägerzylinder schrittweise in Umfangsrichtung bewegt werden. Bei jeder Ruhestellung des Trägerzylinders würde dann in Horizontalrichtung des Trägerzylinders bemustert bzw. belichtet werden. Die Bearbeitungsstationen würden dann in der jeweiligen Ruhestellung des Trägerzylinders in dessen Längsrichtung bewegt werden. Nach Abarbeitung einer Zeile würde sich der Trägerzylinder erneut um einen Schritt weiter drehen, und der Bemusterungs- bzw. Belichtungsvorgang würden wiederholt werden, usw..

Nach der Erfindung kommen als lichtempfindliche Druckplatten vorzugsweise Fotopolymerplatten zum Einsatz, die nach Belichtung entwickelt werden. Dabei können die Fotopolymerplatten auch relativ dick sein, etwa 2 bis 6 mm dick, um möglichst elastische und für den Hochdruck geeignete Druckplatten zu erhalten, mit denen sich auch weicheres Gut beschädigungsfrei bedrucken läßt, etwa Kartonagen bzw. Wellpappe und dergleichen.

Dabei können nach einer noch weiteren Ausgestaltung der Erfindung auch mehrere lichtempfindliche Druckplatten in vorbestimmter Positionsbeziehung auf dem Trägerzylinder zueinander angeordnet und gleichzeitig den jeweiligen Arbeitsgängen unterzogen werden. Auf diese Weise läßt sich Druckplattenmaterial (Fotopolymermaterial) einsparen, da später nur dort auf der Druckwalze Druckplatten zu liegen kommen, wo auf dem zu bedruckenden Gut auch gedruckt werden soll. Um die Positionierung der lichtempfindlichen Druckplatten auf den jeweiligen Zylindern (Trägerzylinder bzw. Druckwalze) zu vereinfachen, können die Druckplatten zuvor auch auf eine Trägerfolie (carrier sheet) geklebt werden, die dann um den Trägerzylinder bzw. um die Druckwalze herumgelegt wird. Die Ausrichtung der einzelnen Druckplatten relativ zueinander kann dann schon auf der Trägerfolie erfolgen und nicht erst auf den jeweiligen Zylindern, was den Ausrichtvorgang vereinfacht.

Eine erfindungsgemäße Vorrichtung zur Herstellung von Druckplatten bzw. Druckmatten enthält einen drehbar gelagerten Trägerzylinder, auf dessen äußerer Umfangsfläche lichtempfindliche Druckplatten bzw. Druckmatten befestigbar sind; eine in Längsrichtung des Trägerzylinders bewegbare Bearbeitungsschlittenanordnung; eine auf der Bearbeitungsschlittenanordnung angeordnete erste Bearbeitungsstation zur Erstellung einer Bemusterungsmaske auf der auf dem Trägerzylinder befestigten Druckplatte bzw. Druckmatte; und eine auf der Bearbeitungsschlittenanordnung angeordnete zweite Bearbeitungsstation, die in Längsrichtung des Trägerzylinders neben der ersten Bearbeitungsstation liegt und zur Belichtung der lichtempfindlichen Druckplatte bzw. Druckmatte durch die Bemusterungsmaske hindurch dient.

Die Bearbeitungsschlittenanordnung kann zum Beispiel aus einem einzigen Bearbeitungsschlitten bestehen, auf dem sowohl die erste und die zweite Bearbeitungsstation angeordnet sind. Andererseits kann die Bearbeitungsschlittenanordnung aber auch aus zwei oder mehreren getrennt voneinander vorhandenen Bearbeitungsschlitten bestehen. Im Falle von zwei Bearbeitungsschlitten sind dann die erste und die zweite Bearbeitungsstation auf verschiedenen Schlitten angeordnet. Die getrennt vorhandenen Bearbeitungsschlitten müssen nicht unbedingt simultan oder mit derselben Geschwindigkeit oder in derselben Richtung bewegt werden. Sie lassen sich auch unabhängig voneinander und in verschiedenen Richtungen bewegen, je nach Bearbeitungsprozeß.

Bei dieser Vorrichtung ist der Durchmesser des drehbar gelagerten Trägerzylinders so gewählt, daß er dem Durchmesser der Druckwalze entspricht, auf die die belichtete und entwickelte Druckplatte bzw. Druckmatte später gelegt wird, um Muster zu drucken. Letztere lassen sich daher im Umfangsrichtung der Druckwalze verzerrungsfrei auf das zu bedruckende Gut aufbringen.

Nach einer Ausgestaltung der erfindungsgemäßen Vorrichtung kann die erste Bearbeitungsstation Strahlung bzw. fokussierte Strahlung, vorzugsweise Laserstrahlung in Richtung auf den Trägerzylinder abstrahlen, um zur Bildung der Bemusterungsmaske eine Abdeckschicht etwa abtragen oder, falls diese fotoempfindlich ist, belichten zu können.

Bei der ersten Bearbeitungsstation kann es sich aber auch um eine Düsenstation handeln, die eine oder mehrere Düsen zum Aufspritzen von Abdeckflüssigkeit in Richtung auf den Trägerzylinder aufweist. Die mehreren Düsen können dabei in Längsrichtung des Trägerzylinders nebeneinanderliegend angeordnet sein. Durch sie läßt sich die Bemusterungsmaske direkt durch Aufspritzen der Abdeckflüssigkeit auf die lichtempfindliche Druckplatte herstellen.

Nach einer vorteilhaften weiteren Ausbildung der erfindungsgemäßen Vorrichtung kann die zweite Bearbeitungsstation als eine sich in Umfangsrichtung des Trägerzylinders erstreckende Belichtungsstation ausgebildet sein. Dadurch läßt sich die Zeit, über die ein Punkt auf der Oberfläche der lichtempfindlichen Druckplatte bei Drehung des Trägerzylinders belichtet wird, verlängern, so daß sich auch relativ dicke Druckplatten über relativ große Tiefen aushärten lassen. Vorzugsweise weist dabei die zweite Bearbeitungsstation mehrere in Umfangsrichtung des Trägerzylinders hintereinander liegende Lichtquellen auf, etwa Metall- Halogen- UV-Lampen, mit denen für eine ausreichende Bestrahlungsstärke im Bereich von etwa 300 bis 400 nm gesorgt werden kann.

Die einzelnen Lichtquellen können dabei vorzugsweise von Lichtreflektoren umgeben sein, um denjenigen Winkel einzustellen, unter dem Licht in die lichtempfindliche Druckplatte eintritt. Dadurch läßt sich die Sockelsteilheit der Belichtungsbereiche im Fotopolymer regulieren, die etwa im Bereich zwischen 25 bis 45 Grad liegen sollte, gemessen ausgehend von der Normalen der Druckplatte.

Die Erfindung wird nachfolgend unter Bezugnahme auf die Zeichnung näher erläutert. Es zeigen:
Fig. 1a bis 1c eine erste erfindungsgemäße Möglichkeit zur Herstellung von Druckplatten;
Fig. 2a und 2b eine zweite erfindungsgemäße Möglichkeit zur Herstellung von Druckplatten;
Fig. 3 eine erste erfindungsgemäße Vorrichtung zur Herstellung von Druckplatten;
Fig. 4 eine vergrößerte Ansicht des rechten Teils der Vorrichtung nach Figur 3; und
Fig. 5 eine zweite erfindungsgemäße Vorrichtung zur Herstellung von Druckplatten.

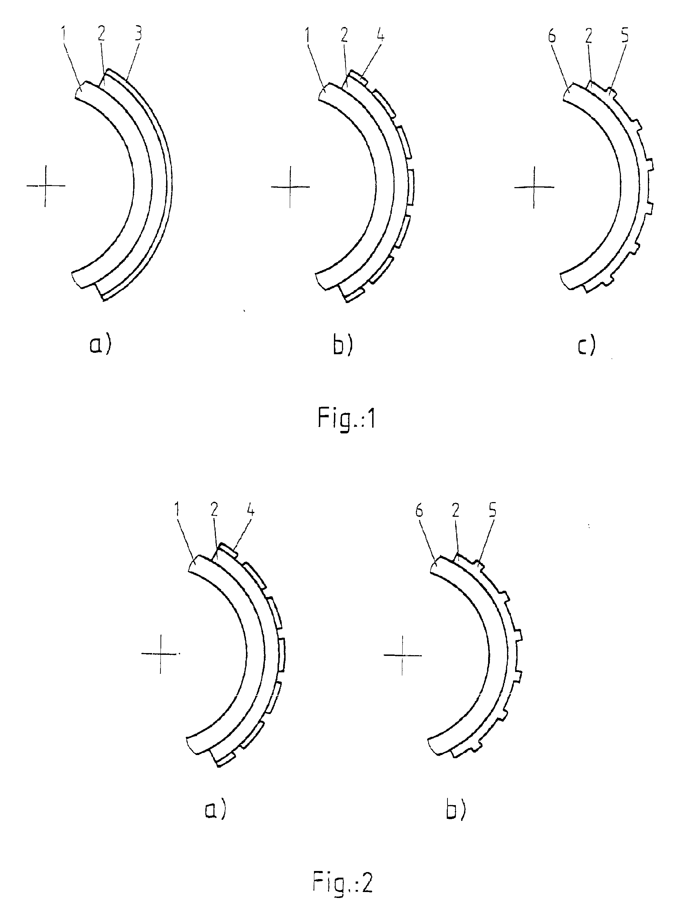

Anhand der Figuren 1 und 2 sollen zunächst 2 Ausführungsbeispiele des erfindungsgemäßen Verfahrens im einzelnen erläutert werden.

Gemäß Figur 1a wird zunächst auf einem hohlen und drehbar gelagerten Trägerzylinder 1 eine lichtempfindliche Druckplatte 2 in geeigneter Weise befestigt, z.B. aufgeklebt. Die lichtempfindliche Druckplatte 2 besteht aus einem Fotopolymermaterial und schmiegt sich an die Oberfläche des Trägerzylinders 1 an. Auf der dem Trägerzylinder 1 abgewandten Oberfläche trägt die lichtempfindlichen Druckplatte 2 eine strahlungsundurchlässige Abdeckschicht 3, die im vorliegenden Fall eine Rußschicht ist. Üblicherweise befindet sich die Rußschicht 3 schon auf der Druckplatte 2, wenn diese auf den Trägerzylinder 1 aufgebracht wird. Möglich wäre es aber auch, die Rußschicht 3 oder eine andere geeignete Abdeckschicht auf die Druckplatte 2 aufzubringen, nachdem diese auf den Trägerzylinder 1 aufgelegt worden ist.

Die Figur 1b zeigt einen Zustand, bei dem die Abdeck- bzw. Rußschicht 3 bereits bereichsweise bzw. musterbedingt entfernt bzw. abgetragen worden ist. Die Abdeckschicht 3 ist hier also schon zur Bemusterungsmaske 4 strukturiert worden. Dies ist dadurch geschehen, daß die Rußschicht 3 mit Hilfe eines fokussierten Laserstrahls weggebrannt worden ist.

Besteht die Abdeckschicht 3 aus einer lichtempfindlichen Lackschicht, so läßt sie sich dadurch zur Bemusterungsmaske 4 strukturieren, daß sie belichtet und anschließend entwickelt wird. Die Belichtung kann z.B. mit Hilfe eines Laserstrahls erfolgen oder auch mit Hilfe einer IR-Diode, wenn es sich bei der Abdeckschicht 3 um eine Materialschicht handelt, die im Infrarotbereich empfindlich ist.

Nach Ausbildung der Bemusterungsmaske 4 auf der Oberfläche der lichtempfindlichen Druckplatte 2 wird letztere durch die Bemusterungsmaske 4 hindurch mit UV-Strahlung belichtet und anschließend entwickelt. Die belichteten Bereiche der Druckplatte 2 härten aus und bilden nach Entwicklung erhabene Bereich 5, wie in Figur 1c zu erkennen ist. Die nicht belichteten Bereiche der Druckplatte 2 werden bei der Entwicklung je nach Entwicklungsdauer über eine vorbestimmte Tiefe herausgelöst (Auswaschvorgang). Die vorbestimmte Tiefe ergibt sich durch vorheriges Rückbelichten, bei dem die Polymerplatte von hinten, also von der nichtdruckenden Seite, belichtet wird. Diese Belichtungszeit bestimmt die erreichbare Relieftiefe.

Nachdem die Druckplatte 2 gemäß Figur 1b durch die Bemusterungsmaske 4 hindurch mit UV-Strahlung belichtet worden ist, kann sie vom Trägerzylinder 1 abgenommen und im flachen Zustand entwickelt werden. Bei der Entwicklung würden die Musterstrukturen zwar aufeinanderzu gedrückt werden, wenn eine Entwicklung im ebenen Zustand der Druckplatte erfolgt, was jedoch unschädlich ist, da nach der Entwicklung die Druckplatte 2 wieder auf eine zylindrische Druckwalze 6 gemäß Figur 1c aufgelegt wird und sich somit die Musterstrukturen wieder in Umfangsrichtung der Druckwalze 6 voneinander entfernen, so daß letztlich beim Zustand gemäß Figur 1 c keine Verzerrung des Musters gegenüber dem Zustand nach Figur 1b auftritt. Vorzugsweise sind die Durchmesser des Trägerzylinders 1 und der Druckwalze 6 wenigstens annäherungsweise gleich. Natürlich könnte man auch daran denken, die Entwicklung der Druckplatte 2 vorzunehmen, wenn sie sich noch auf dem Trägerzylinder 1 befindet. Dies würde den Herstellungsprozeß vereinfachen, allerdings eine kompliziertere Belichtungs-/Entwicklungsvorrichtung erfordern.

Die Figur 2 zeigt eine weitere Möglichkeit der Herstellung von Druckplatten.

Gemäß Figur 2a wird wiederum auf die äußere Oberfläche eines Trägerzylinders 1 eine lichtempfindliche Druckplatte 2 aus Fotopolymermaterial aufgebracht, z.B. aufgeklebt. Auf die dem Trägerzylinder 1 abgewandte Oberfläche der Druckplatte 2 wird dann eine Bemusterungsmaske 4 aufgebracht, indem z.B. musterbedingt Abdeckmaterial aufgetragen wird. Diese Abdeckmaterial zur Maskenbildung kann z.B. mit Hilfe von Düsen aufgespritzt werden. Zu diesem Zweck könnte als Abdeckmaterial flüssiges Wachs, Tinte, ein Farbstoff, Lack oder auch flüssiges Metall (Woodsches Metall) verwendet werden. Möglich ist es aber auch, zur Bildung der Bemusterungsmaske 4 pastöses oder festes Material auf die Oberfläche der Druckplatte 2 aufzubringen, das dort haftet, etwa durch eine Walzenanordnung, oder dergleichen.

Die mit der Bemusterungsmaske versehene Druckplatte 2 wird dann durch die Bemusterungsmaske 4 hindurch mit UV-Strahlung belichtet und anschließend entwickelt. Die Entwicklung kann wiederum entweder auf dem Trägerzylinder 1 oder separat davon und in einem ebenen Zustand der Druckplatte 2 erfolgen.

Gemäß Figur 2b wird dann für einen Druckvorgang die entwickelte Druckplatte 2 auf die Oberfläche einer Druckwalze 6 gelegt, die etwa den selben Außendurchmesser aufweist wie der Trägerzylinder 1. In Umfangsrichtung der Druckwalze 6 gesehen weisen dann die erhabenen Strukturen 5 der Druckplatte 2 den selben Abstand voneinander auf wie die belichteten Bereiche der Druckplatte 2 gemäß Zustand nach Figur 2a. Eine Musterverzerrung in Umfangsrichtung der Druckwalze 6 tritt somit nicht mehr auf.

Prinzipiell können die Strukturierung der Abdeckschicht bzw. das Aufbringen der Bemusterungsmaske sowie das Belichten der lichtempfindlichen Druckplatte durch die Bemusterungsmaske hindurch bei ruhendem Trägerzylinder erfolgen, jedoch müßten dann die entsprechenden Bearbeitungsstationen in der entsprechenden Fläche bewegt werden. Vorteilhafter kann es sein, den Trägerzylinder um seine Längsachse zu drehen und die jeweiligen Bearbeitungsstationen bei Drehung des Trägerzylinders 1 um seine Längsachse in Richtung der Längsachse zu bewegen.

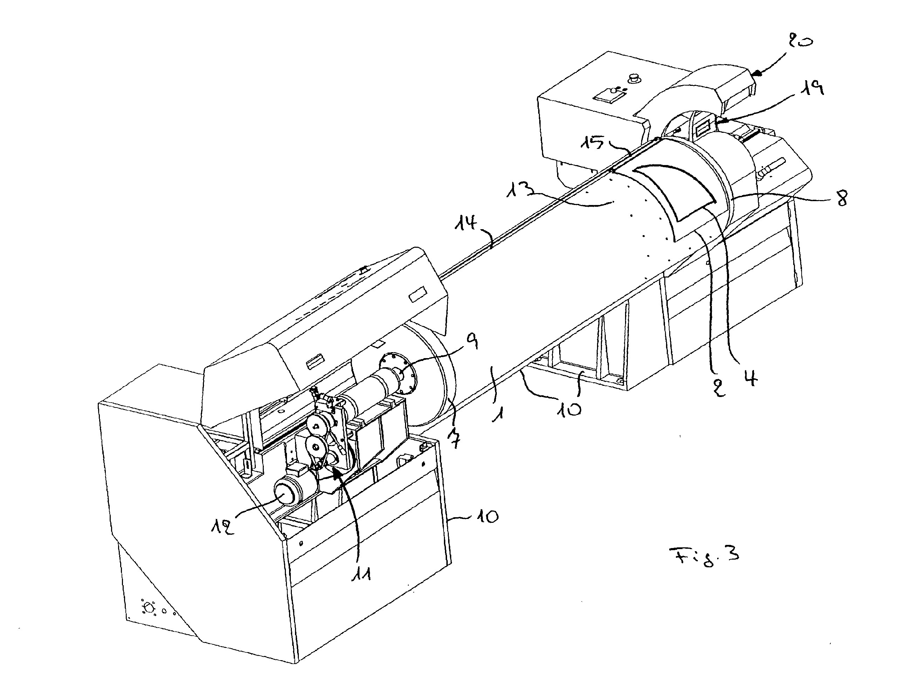

Die Figuren 3 bis 5 beziehen sich auf Vorrichtungen, die im zuletzt genannten Sinne arbeiten.

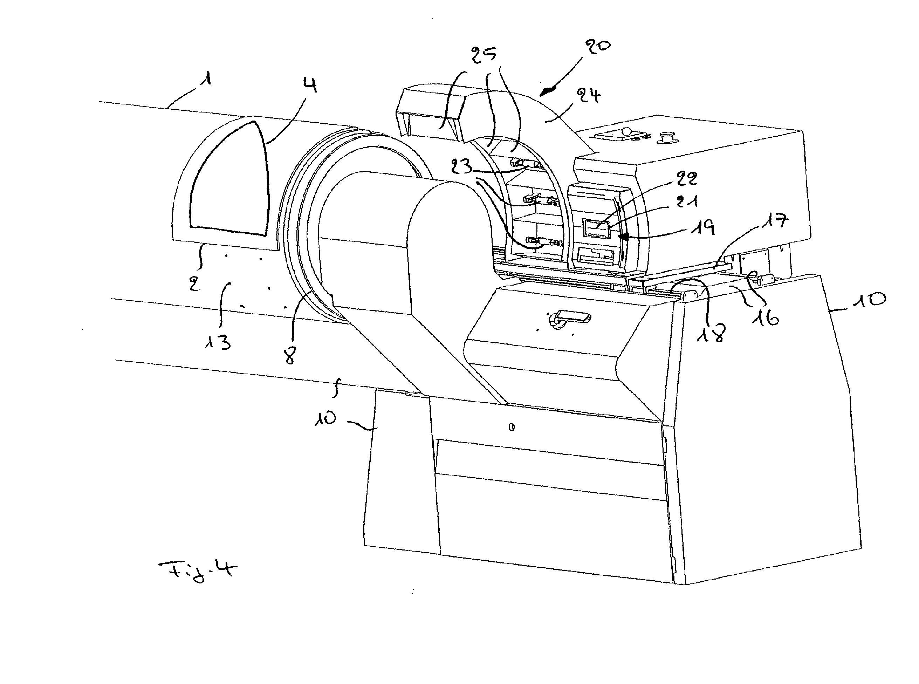

Eine erfindungsgemäße Vorrichtung gemäß den Figuren 3 und 4 weist zunächst einen drehbar gelagerten Trägerzylinder auf. Der Trägerzylinder 1 besteht aus einem starren Hohlrohr, etwa aus Aluminium, und ist über stirnseitige Endflansche 7 und 8 mit Achsstummeln 9 verbunden, die in nicht näher bezeichneten Lagern gelagert sind, welche sich auf einem Maschinenbett 10 abstützen. Über einen dieser Achsstummel 9 ist der Trägerzylinder 1 drehbar, und zwar über einen Riementrieb 11, der von einem Motor 12 angetrieben wird. Der Trägerzylinder 1 bildet zusammen mit den Endflanschen 7,8 einen Druckraum, der über einen der hohl ausgebildeten Endflansche mittels einer nicht näher dargestellten Pumpvorrichtung evakuiert werden kann. Radiale Durchgangsöffnungen in der Umfangswand des Trägerzylinders 1 saugen somit Luft von außen an und können dadurch einen auf den Trägerzylinder 1 aufgelegten flachen Gegenstand in Richtung zum Trägerzylinder 1 ziehen. Zur Verdeutlichung sind einige radiale Durchgangsöffnungen in Figur 3 mit den Bezugszeichen 13 versehen. Ein Längsschlitz 14 in der Oberfläche des Trägerzylinders 1 dient zur Aufnahme einer Klemmleiste 15, über die ein mit der Klemmleiste 15 verbundener flacher Gegenstand am Trägerzylinder 1 befestigt werden kann. Beim flachen Gegenstand handelt es sich hier um die besagte lichtempfindliche Druckplatte bzw. Druckmatte 2. Sie wird zunächst von der Klemmleiste 15 klemmend entlang einer Längskante aufgenommen, wonach die Klemmleiste 15 in den Längsschlitz 14 eingehängt wird. Nach Ausbildung einer Saugwirkung im inneren des Trägerzylinders 1 wird die Druckplatte 2 gegen dessen äußere Umfangsfläche gesaugt, und der Trägerzylinder 1 wird so um seine Längsachse angetrieben, daß die Klemmleiste 15 in Bewegungsrichtung vorne liegt.

Prinzipiell wäre es auch möglich, auf den Längsschlitz und die Klemmleiste zu verzichten und die lichtempfindliche Druckplatte 2 direkt auf die Umfangsoberfläche des Trägerzylinders 1 aufzukleben.

Wie die Figuren 3 und 4 weiter erkennen lassen, befindet sich auf dem Maschinenbett 10 eine Längsführung 16 für einen Bearbeitungsschlitten 17. Die Längsführung 16 erstreckt sich parallel zur Längsachse des Trägerzylinders 1 und gestattet eine Führung des Bearbeitungsschlittens 17 in dieser Richtung. Zum Antrieb des Bearbeitungsschlittens 17 in Längsrichtung des Trägerzylinders 1 ist eine Spindel 18 vorgesehen, die parallel zur Längsführung 16 liegt und bei ihrer Drehung den Bearbeitungsschlitten 17 in der einen oder anderen Richtung mitnimmt. Zum Antrieb der Spindel 18 sind nicht näher dargestellte Antriebsmittel vorgesehen.

Auf dem Bearbeitungsschlitten 17 befinden sich eine erste Bearbeitungsstation 19 und eine zweite Bearbeitungsstation 20.

Die erste Bearbeitungsstation 19 weist eine Düsenanordnung 21 mit einer großen Anzahl von Düsen 22 auf, die in Längsrichtung des Trägerzylinders 1 nebeneinanderliegend und im Abstand voneinander angeordnet sind. Mit Hilfe der Düsen 22 läßt sich eine Abdeckflüssigkeit in Richtung zum Trägerzylinder 1 ausspritzen, um auf diese Weise die auf dem Trägerzylinder 1 liegende Druckplatte 2 musterbedingt abzudecken. Dadurch wird auf der Druckplatte 2 eine Bemusterungsmaske 4 erhalten, wie in den Figuren 3 und 4 angedeutet ist. Die Bemusterungsmaske 4 wird bei Drehung des Trägerzylinders 1 um seine Längsachse und gleichzeitiger Verschiebung des Bearbeitungsschlittens 17 in Richtung der Längsachse des Trägerzylinders 1 bei geeigneter Ansteuerung der Düsen 22 erzeugt. Die Ansteuerung der Düsen erfolgt dabei über einen nicht gezeigten Rechner, in welchem die Bemusterungsmaske 4 in digitaler Weise gespeichert ist. Möglich ist es dabei, die Bemusterungsmaske 4 bei jeweils stationärem Bearbeitungsschlitten 17 abschnittsweise zu erzeugen oder bei kontinuierlich bewegtem Bearbeitungsschlitten 17. Durch die in Bewegungsrichtung hinter der Düsenanordnung 21 befindliche zweite Bearbeitungsstation 20 kann die Druckplatte 2 unmittelbar im Anschluß an das Aufbringen der jeweiligen Abschnitte der Bemusterungsmaske belichtet werden, um die nicht abgedeckten Bereiche der Fotopolymerplatte 2 zu härten. Insofern erfolgen das Aufbringen der Abdeckschicht und das Belichten des nicht abgedeckten Teils der Druckplatte 2 "ON-FLY", also bei ein und derselben Bewegung des Bearbeitungsschlitten 17, bzw. in einem Arbeitsgang.

Die zweite Bearbeitungsstation 20 weist zur Belichtung der nicht abgedeckten Bereiche der Druckplatte 2 mehrere in Umfangsrichtung des Trägerzylinders 1 im Abstand voneinander angeordnete UV-Lampen 23 auf, die z.B. Metall-Halogen-Lampen sind und in einem Wellenbereich von 300 bis 400 nm strahlen. Sie befinden sich an der konkaven Seite eines bogenförmig ausgebildeten Trägers 24. Bei Drehung der Druckplatte 2 entlang des Trägers 24 wird somit jeder Punkt der Druckplatte 2 durch die Mehrzahl der UV-Lampen 23 über längere Zeit belichtet, so daß die Druckplatte 2 auch verhältnismäßig tief ausgehärtet werden kann.

Nach vollständiger UV-Belichtung der Druckplatte 2 unter Verwendung der Bemusterungsmaske 4 wird die Druckplatte 2 vom Trägerzylinder 1 abgenommen und kann jetzt in flachem bzw. ebenen Zustand durch ein Entwicklerbad geleitet werden, um entwickelt zu werden. Die Herstellung der Druckplatte ist damit beendet. Soll sie später zu Druckzwecken verwendet werden, wird sie in ähnlicher Weise wie bei der Belichtung auf eine zylindrische Druckwalze gelegt, die etwa den selben Durchmesser wie der Trägerzylinder 1 aufweist, um dann als Hochdruckform ebenes Gut zu bedrucken. Verzerrungen innerhalb des zu druckenden Musters treten nicht mehr auf, da jetzt die Druckplatte 2 dieselbe Krümmung aufweist wie bei ihrer Herstellung auf dem Trägerzylinder 1.

Es sei noch darauf hingewiesen, daß am Träger 24 innenseitig und zwischen den jeweiligen UV-Lampen 23 sowie an deren Seitenbereichen Reflektoren 25 angeordnet sind, die dafür sorgen, daß das von den UV-Lampen 23 abgestrahlte Licht nur unter bestimmten Winkeln in das Fotopolymer eindringen kann. Je nach Stellung der Reflektoren 25, die auch verstellbar sein können, läßt sich somit die Sockelsteilheit der Belichtungsstrukturen im Fotopolymer einstellen. Dadurch wird es möglich, insbesondere bei relativ dicken Druckplatten 2 auch bei geringen Abständen zwischen den einzelnen Strukturen tiefe Gräben zwischen ihnen zu erhalten.

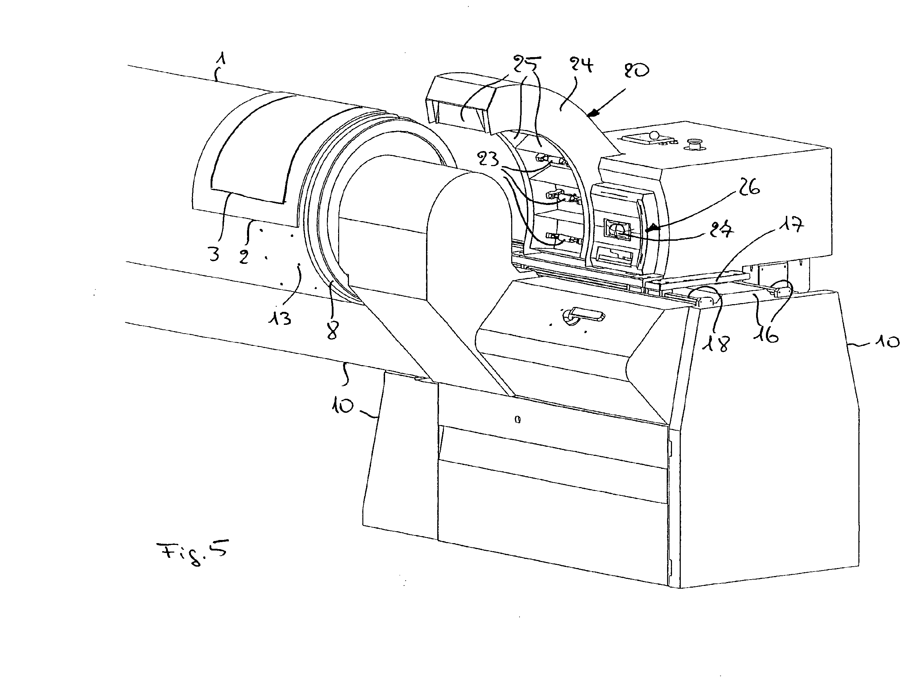

Die Figur 5 zeigt eine Abwandlung der erfindungsgemäßen Vorrichtung. Hier befindet sich auf dem Bearbeitungsschlitten 17 eine erste Bearbeitungsstation 19, die mit einem Laser- Bestrahlungssystem 26 ausgestattet ist. Ansonsten liegen gleiche Verhältnisse wie bei den Vorrichtungen nach den Figuren 3 und 4 vor. Das Laser- Bestrahlungssystem 26 weist in seinem inneren einen nicht dargestellten Laser zur Erzeugung eines Laserstrahls auf, der mittels einer Linsenoptik 27 auf die Oberfläche der Druckplatte 2 fokussiert ist. Mit Hilfe des durch die Linsenoptik 27 fokussierten Laserstrahls ist es somit möglich, eine auf der Druckplatte 2 liegenden und bereits vorher aufgebrachte Abdeckschicht 3 musterbedingt wegzubrennen, wozu bei Drehung des Trägerzylinders 1 und entsprechender Verschiebung des Bearbeitungsschlittens 17 der Laserstrahl entweder gepulst oder bereichsweise im Dauerbetrieb betrieben wird. Auf diese Weise wird die Abdeckschicht 3 in eine Bemusterungsmaske 4 überführt. Anschließend wird wiederum die Druckplatte 2 durch die so erhaltene Bemusterungsmaske 4 hindurch belichtet, und zwar mit Hilfe der zweiten Bearbeitungsstation 20 bzw. Belichtungsstation. Danach erfolgen die bereits oben beschriebenen Vorgänge bezüglich der Entwicklung und der Verwendung als Hochdruckplatte auf einer Druckwalze zum Bedrucken von ebenem Gut, etwa Kartonagen, und dergleichen.

Von den zuvor beschriebenen Ausführungsbeispielen könnten die erste Bearbeitungsstation und die zweite Bearbeitungsstation auch auf voneinander getrennten und getrennt voneinander bewegbaren Schlitten angeordnet sein. Dabei können die getrennten Schlitten auch mit verschiedenen Geschwindigkeiten und in verschiedenen Richtungen bewegt werden. So könnte zum Beispiel der Bemusterungsschlitten schneller bewegt werden als der Belichtungsschlitten, um materialabhängig eine längere Belichtungszeit vorsehen zu können.

## Patentansprüche

1. Verfahren zur Herstellung von Druckplatten, bei dem
- wenigstens eine lichtempfindliche Druckplatte (2) auf die äußere Umfangsfläche eines Trägerzylinders (1) gelegt und
- auf diesem durch eine Bemusterungsmaske (4) hindurch belichtet wird.

2. Verfahren nach Anspruch 1, **dadurch gekennzeichnet, daß** die Bemusterungsmaske (4) durch Strukturierung einer auf der lichtempfindlichen Druckplatte (2) liegenden Abdeckschicht (3) gebildet wird.

3. Verfahren nach Anspruch 2, **dadurch gekennzeichnet, daß** als Abdeckschicht (3) eine Rußschicht verwendet wird.

4. Verfahren nach Anspruch 2, **dadurch gekennzeichnet, daß** als Abdeckschicht (3) eine lichtempfindliche Schicht verwendet wird.

5. Verfahren nach Anspruch 4, **dadurch gekennzeichnet, daß** als lichtempfindliche Schicht (3) eine im Infraroten empfindliche Schicht verwendet wird.

6. Verfahren nach einem der Ansprüche 2 bis 5, **dadurch gekennzeichnet, daß** die Abdeckschicht (3) durch Bestrahlung strukturiert wird.

7. Verfahren nach Anspruch 6, **dadurch gekennzeichnet, daß** zur Strukturierung der Abdeckschicht (3) fokussierte Strahlung eingesetzt wird.

8. Verfahren nach Anspruch 6 oder 7, **dadurch gekennzeichnet, daß** die bestrahlte Abdeckschicht (3) entwickelt wird.

9. Verfahren nach Anspruch 7, **dadurch gekennzeichnet, daß** die Abdeckschicht (3) durch Bestrahlung abgetragen wird.

10. Verfahren nach einem der Ansprüche 2 bis 9, **dadurch gekennzeichnet, daß** das Strukturieren der Abdeckschicht (3) und das Belichten der lichtempfindlichen Druckplatte (2) bei sich kontinuierlich oder schrittweise drehendem Trägerzylinder (1) erfolgt.

11. Verfahren nach Anspruch 9 und 10, **dadurch gekennzeichnet, daß** das Abtragen der Abdeckschicht (3) und das Belichten der lichtempfindlichen Druckplatte (2) im selben Arbeitsgang durch in Längsrichtung des Trägerzylinders (1) voneinander beabstandete Strahlungsquellen (26, 23) erfolgt, wenn sie in dieser Richtung bewegt werden.

12. Verfahren nach Anspruch 1, **dadurch gekennzeichnet, daß** die Bemusterungsmaske (4) durch musterbedingtes Aufbringen einer Abdeckflüssigkeit auf die Oberfläche der lichtempfindlichen Druckplatte (2) gebildet wird.

13. Verfahren nach Anspruch 12, **dadurch gekennzeichnet, daß** die Abdeckflüssigkeit aufgespritzt wird.

14. Verfahren nach Anspruch 12 oder 13, **dadurch gekennzeichnet, daß** als Abdeckflüssigkeit Wachs, Tinte oder flüssiges Metall verwendet wird.

15. Verfahren nach einem der Ansprüche 12 bis 14, **dadurch gekennzeichnet, daß** das Aufbringen der Abdeckflüssigkeit und das Belichten der lichtempfindlichen Druckplatte (2) bei sich kontinuierlich oder schrittweise drehendem Trägerzylinder (1) erfolgt.

16. Verfahren nach Anspruch 15, **dadurch gekennzeichnet, daß** das Aufbringen der Abdeckflüssigkeit und das Belichten der lichtempfindlichen Druckplatte (2) im selben Abreitsgang durch in Längsrichtung des Trägerzylinders (1) voneinander beabstandete Bearbeitungsstationen (19, 20) erfolgt, wenn sie in dieser Richtung bewegt werden.

17. Verfahren nach einem der Ansprüche 1 bis 16, **dadurch gekennzeichnet, daß** die belichtete Druckplatte (2) entwickelt wird.

18. Verfahren nach einem der Ansprüche 1 bis 17, **dadurch gekennzeichnet, daß** mehrere lichtempfindliche Druckplatten in vorbestimmter Positionsbeziehung auf dem Trägerzylinder (1) angeordnet und gleichzeitig den jeweiligen Arbeitsgängen unterzogen werden.

19. Verfahren nach einem der Ansprüche 1 bis 18, **dadurch gekennzeichnet, daß** als lichtempfindliche Druckplatten Fotopolymerplatten verwendet werden.

20. Vorrichtung zur Herstellung von Druckplatten, mit:
- einem drehbar gelagerten Trägerzylinder (1), auf dessen äußerer Umfangsfläche lichtempfindliche Druckplatten (2) befestigbar sind;
- einer in Längsrichtung des Trägerzylinders (1) bewegbaren Bearbeitungsschlittenanordnung (17);
- einer auf der Bearbeitungsschlittenanordnung (17) angeordneten ersten Bearbeitungsstation (19,26) zur Erstellung einer Bemusterungsmaske (4) auf der auf dem Trägerzylinder (1) befestigten Druckplatte (2); und
- einer auf der Bearbeitungsschlittenanordnung (17) angeordneten zweiten Bearbeitungsstation (20), die in Längsrichtung des Trägerzylinders (1) beabstandet von der ersten Bearbeitungsstation (19, 26) liegt und zur Belichtung der lichtempfindlichen Druckplatte (2) durch die Bemusterungsmaske (4) hindurch dient.

21. Vorrichtung nach Anspruch 21, **dadurch gekennzeichnet, daß** die erste Bearbeitungsstation (26) Strahlung bzw. fokussierte Strahlung, vorzugsweise Laserstrahlung in Richtung auf den Trägerzylinder () abstrahlt.

22. Vorrichtung nach Anspruch 21, **dadurch gekennzeichnet, daß** die erste Bearbeitungsstation (19) als Düsenstation mit einer oder mehreren Düsen (22) zum Anspritzen von Abdeckflüssigkeit in Richtung auf den Trägerzylinder (1) ausgebildet ist.

23. Vorrichtung nach Anspruch 22, **dadurch gekennzeichnet, daß** die zweite Bearbeitungsstation (20) als eine sich in Umfangsrichtung des Trägerzylinders (1) erstreckende Belichtungsstation ausgebildet ist.

24. Vorrichtung nach Anspruch 23, **dadurch gekennzeichnet, daß** die zweite Bearbeitungsstation (20) mehrere in Umfangsrichtung des Trägerzylinders (1) hintereinanderliegende Lichtquellen (23) aufweist.

25. Vorrichtung nach Anspruch 24, **dadurch gekennzeichnet, daß** die Lichtquellen (23) von Lichtreflektoren (25) zur Einstellung des Winkels umgeben sind, unter dem Licht in die lichtempfindliche Druckplatte (2) eintritt.

26. Vorrichtung nach einem der Ansprüche 20 bis 35, **dadurch gekennzeichnet, daß** die erste und die zweite Bearbeitungsstation (19, 26 bzw. 20) auf ein und denselben Bearbeitungsschlitten angeordnet sind.

27. Vorrichtung nach einem der Ansprüche 20 bis 25, **dadurch gekennzeichnet, daß** die erste und die zweite Bearbeitungsstation (19, 26 bzw. 20) auf verschiedenen Bearbeitungsschlitten angeordnet sind.
